# EUROPEAN PATENT APPLICATION

(11) **EP 4 668 508 A1**
(43) Date of publication of application: **24.12.2025**
(21) Application number: 25180688.1
(22) Date of filing: 04.06.2025
(51) Int. Cl.: H02B 1/052, H05K 7/14, H05K 7/12

(54) **MOUNTING UNIT AND NODE UNIT**

(30) Priority: 21.06.2024 JP 2024100430
(71) Applicant: Yokogawa Electric Corporation, Tokyo 180-8750 (JP)
(72) Inventor: KUROIWA, Daisuke, Musashino-shi, Tokyo 180-8750, (JP)
(74) Representative: Winter, Brandl - Partnerschaft mbB

(57) **Abstract**

A mounting unit is for mounting a structure on a rail member 11 provided on a wall surface 10. The mounting unit includes: an attachment and detachment unit 6 that is mounted on an extended portion 53 extending out from an outer edge of the structure in a case where the attachment and detachment unit 6 is viewed along a first direction perpendicular to the wall surface 10 and that is attachable to and detachable from the rail member 11; and at least two opposed portions 72 that are mounted on the extended portion 53, opposed to the wall surface 10 by protruding more toward the wall surface 10 than the extended portion 53, and formed of resin. The attachment and detachment unit 6 has a resin portion that provides insulation between the rail member 11 and the extended portion 53. The opposed portions 72 are provided to be arranged along the outer edge and provided on both sides of the attachment and detachment unit 6, with the attachment and detachment unit 6 interposed between the opposed portions 72.

## Description

### CROSS-REFERENCE TO RELATED APPLICATION(S)

The present application claims priority to and incorporates by reference the entire contents of Japanese Patent Application No. 2024-100430 filed in Japan on June 21, 2024.

### FIELD

The present invention relates to a mounting unit and a node unit.

### BACKGROUND

Structures may be mounted on a rail member (for example, a DIN rail) fixed to a wall surface via a mounting unit. In a case where a structure vertically larger than a rail member is mounted on the rail member, the structure tends to be shaken vertically.

A configuration provided with a mounting unit on a back surface of a structure is disclosed in Japanese Patent No. 6000090, the mounting unit including an adapter and an auxiliary metal part. The structure is mounted on a rail member by means of the adapter. Furthermore, the auxiliary metal part provided on the back surface of the structure is abutted against a wall surface in an attempt to reduce vibration of the structure.

Because the adapter and the auxiliary metal part are provided on the back surface of the structure in the mounting unit disclosed in Japanese Patent No. 6000090, there is a problem that the adapter and the auxiliary metal part are difficult to be accessed after the structure is mounted on the rail member and attaching and detaching operation, for example, thus becomes difficult to be performed.

An object of the present invention is to obtain a mounting unit that increases ease of operation for attaching and detaching a structure to and from a wall surface.

### SUMMARY

According to an aspect of an embodiment, a mounting unit for mounting a structure on a rail member provided on a wall surface, the mounting unit comprising: an attachment and detachment unit mounted on an extended portion extending out from an outer edge of the structure in a case where the attachment and detachment unit is viewed along a first direction perpendicular to the wall surface, the attachment and detachment unit being attachable to and detachable from the rail member; and at least two opposed portions that are mounted on the extended portion, opposed to the wall surface by protruding more toward the wall surface than the extended portion, and formed of resin, wherein the attachment and detachment unit has a resin portion that provides insulation between the rail member and the extended portion, and the opposed portions are provided to be arranged along the outer edge and are provided on both sides of the attachment and detachment unit, with the attachment and detachment unit interposed between the opposed portions.

### BRIEF DESCRIPTION OF THE DRAWINGS

FIG. 1 is a perspective view illustrating a state where a node unit according to a first embodiment has been installed in a control panel;
FIG. 2 is a side view illustrating the state where the node unit according to the first embodiment has been installed in the control panel;
FIG. 3 is a perspective view of a mounting unit;
FIG. 4 is a side view of the mounting unit;
FIG. 5 is an exploded perspective view of the mounting unit;
FIG. 6 is an exploded perspective view of an attachment and detachment unit; and
FIG. 7 is an exploded perspective view of a vibration reduction unit.

### DETAILED DESCRIPTION OF THE PREFERRED EMBODIMENTS

A mounting unit and a node unit according to an embodiment of the present invention will hereinafter be described in detail by reference to the drawings. The present invention is not to be limited by the embodiment described hereinafter.

### First Embodiment

### Schematic Configuration of Node Unit

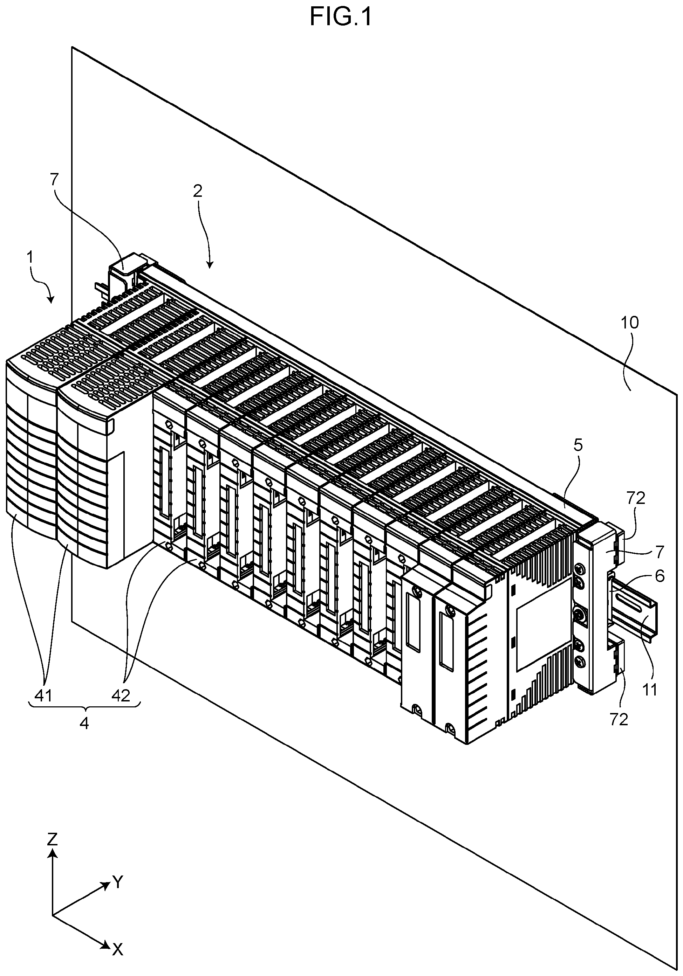

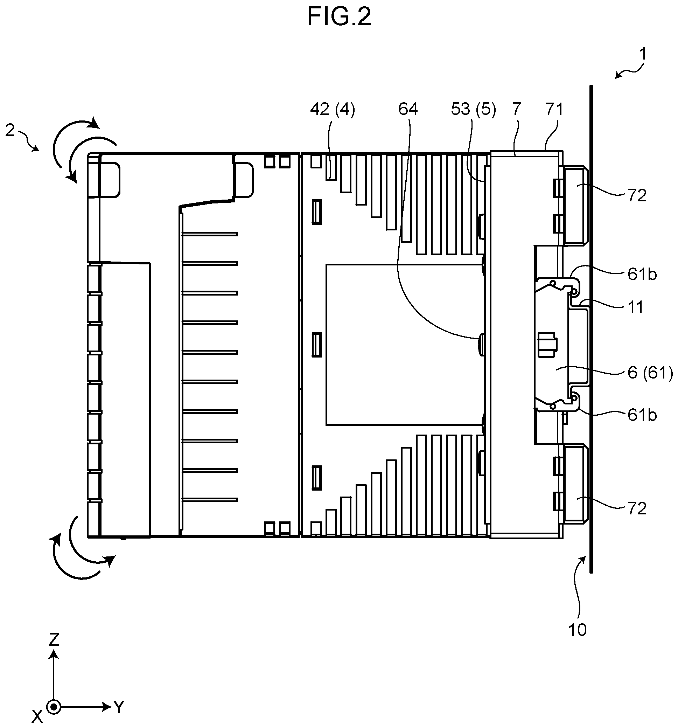

FIG. 1 is a perspective view illustrating a state where a node unit according to a first embodiment has been installed in a control panel. FIG. 2 is a side view illustrating the state where the node unit according to the first embodiment has been installed in the control panel. A node unit 1 includes a mounting unit 2 and a module unit 4. The mounting unit 2 and the module unit 4 are examples of structures to be mounted on a rail member 11 fixed to a wall surface 10 in the control panel. Various machines and various devices, of which illustration has been omitted, are connected to the node unit 1. The node unit 1 includes the module unit 4 exemplified by a programmable logic controller (PLC) or a distributed control system (DCS) and controls the various machines and the various devices connected to the node unit 1.

### Mounting Unit

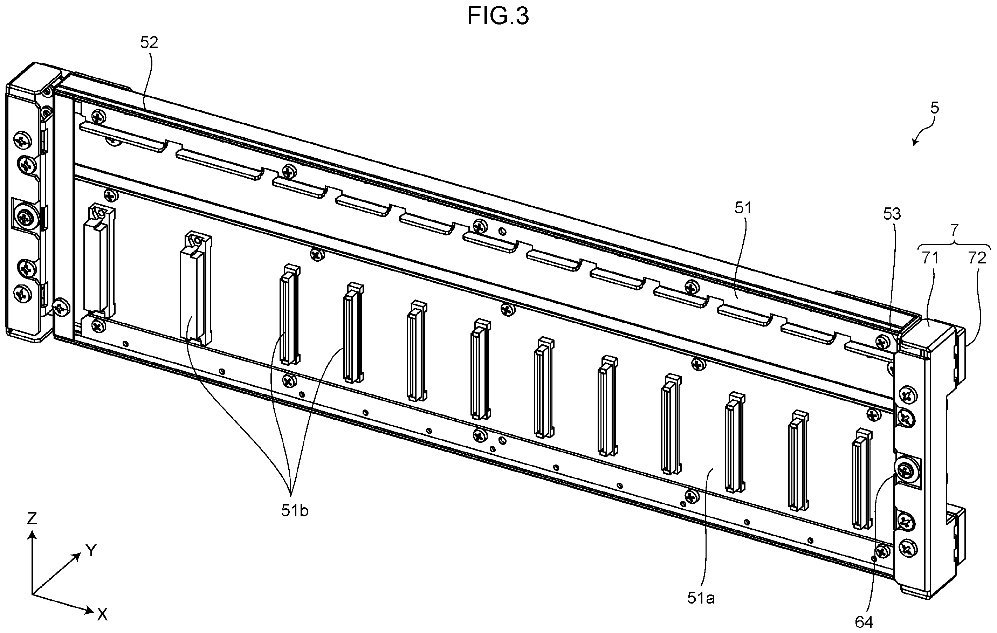

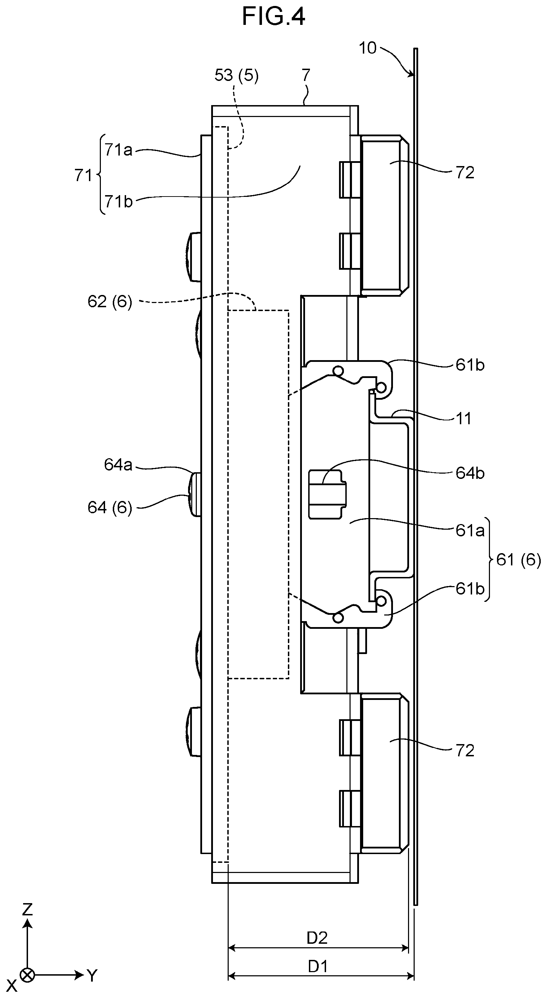

FIG. 3 is a perspective view of a mounting unit. FIG. 4 is a side view of the mounting unit. The mounting unit 2 holding the module unit 4 is mounted on the wall surface 10. Specifically, the mounting unit 2 is mounted on the rail member 11 fixed to the wall surface 10. The rail member 11 is, for example, a DIN rail. FIG. 4 illustrates, in addition to the mounting unit 2, the wall surface 10 and the rail member 11. The mounting unit 2 includes a base 5, an attachment and detachment unit 6, and a vibration reduction unit 7.

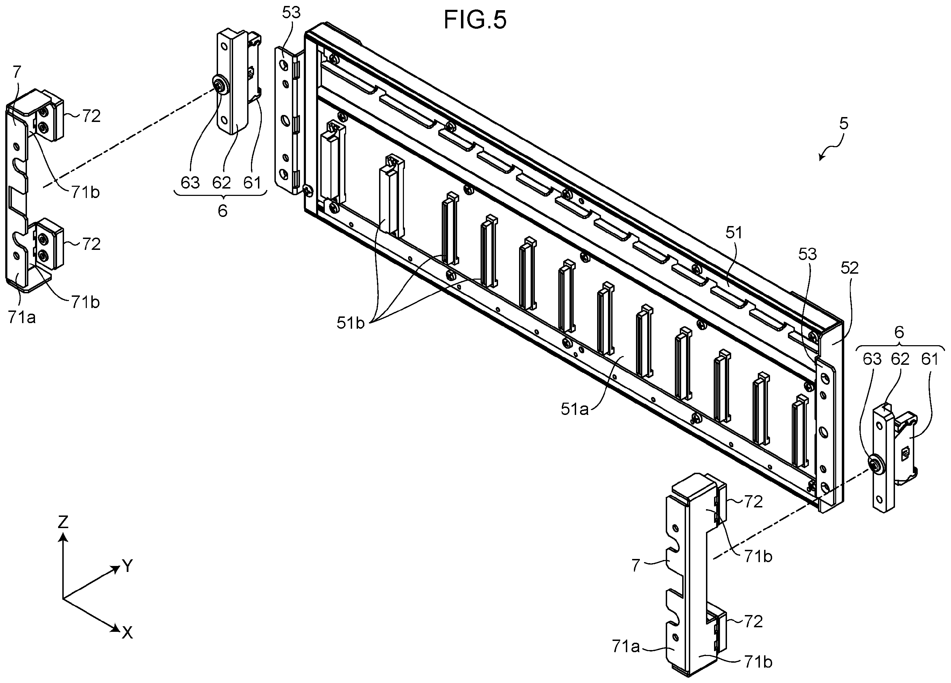

FIG. 5 is an exploded perspective view of the mounting unit. The base 5 is formed of metal. The base 5 has a mounting surface 51 that is rectangular-shaped in a front view thereof. An example where long sides of a rectangle forming the mounting surface 51 extend in a horizontal direction and short sides thereof extend in a vertical direction is illustrated with respect to the first embodiment, but the mounting surface 51 is not limited to this example. The short sides may extend in the horizontal direction and the long sides may extend in the vertical direction, or the mounting surface 51 may be square-shaped.

A Y-axis extending perpendicularly to the mounting surface 51 is defined herein. An X-axis extending parallel to the mounting surface 51 and parallel to the long sides of the rectangle forming the mounting surface 51 is also defined herein. Furthermore, a Z-axis extending parallel to the mounting surface 51 and parallel to the short sides of the rectangle forming the mounting surface 51 is defined herein. In addition, a positive direction along the Y-axis is defined as a backward direction and a negative direction along the Y-axis as a forward direction. A positive direction along the X-axis is defined as a rightward direction and a negative direction along the X-axis as a leftward direction. A positive direction along the Z-axis is defined as an upward direction and a negative direction along the Z-axis as a downward direction. A direction along the Y-axis is a first direction.

A board 51a is provided on the mounting surface 51. Plural connectors 51b are provided to be arranged in the rightward or leftward direction on the board 51a. The connectors 51b are connected to connectors (not illustrated in the drawings) formed on the module unit 4. A holding structure that holds the module unit 4 connected to the connectors 51b is formed on the base 5 but illustration and description of details of the holding structure will be omitted.

A wall portion 52 surrounding a periphery of the mounting surface 51 is formed on the base 5, the wall portion 52 extending forward from outer edges of the mounting surface 51. An extended portion 53 extending out from outer edges of the mounting surface 51 in a front view of the base 5 is formed on the base 5. A front view refers to a state where a target is viewed in a direction perpendicular to the mounting surface 51, that is, along the Y-axis (first direction).

The extended portion 53 is formed to extend out from a forward end portion of the wall portion 52, that is, a distal end of the wall portion 52. Therefore, the extended portion 53 is formed more forward than the mounting surface 51. The extended portion 53 is formed to extend out from short sides of the mounting surface 51 that is rectangular-shaped. That is, the extended portion 53 is formed to extend out from the mounting surface 51, both rightward and leftward, in the front view.

### Attachment and Detachment Unit

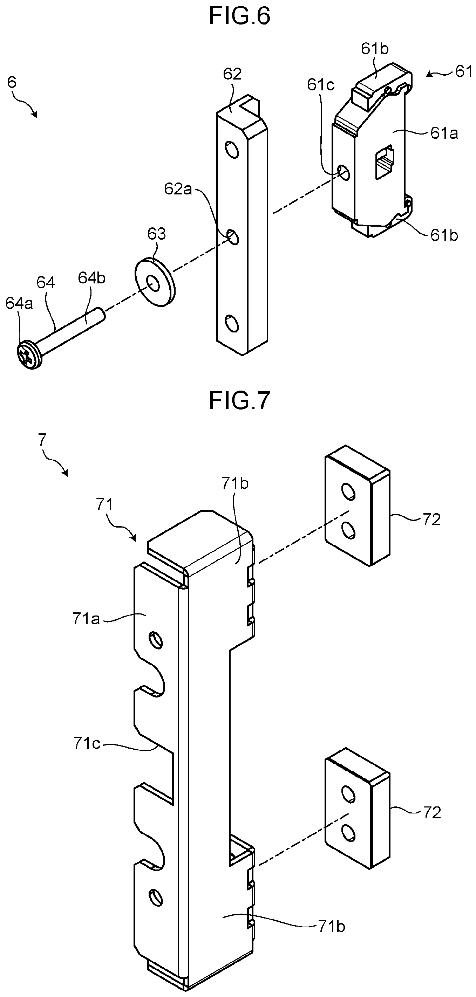

As illustrated in FIG. 4, the attachment and detachment unit 6 is mounted on the extended portion 53. FIG. 6 is an exploded perspective view of an attachment and detachment unit. The attachment and detachment unit 6 includes an attachment 61, a spacer (resin portion) 62, a collar 63, and a fastening member 64.

The attachment 61 is attached to the extended portion 53 in back of the extended portion 53. The attachment 61 has a base portion 61a. Two claw portions 61b are provided on the base portion 61a. The two claw portions 61b are provided to be capable of operating to change a distance between the two claw portions 61b. In a case where the two claw portions 61b are at positions near in distance from each other, the two claw portions 61b hold the rail member 11 between the two claw portions 61b to fix the attachment 61 to the rail member 11. In a case where the two claw portions 61b are at positions far in distance from each other, the two claw portions 61b do not hold the rail member 11 between the two claw portions 61b and allow the attachment 61 to be attached to or detached from the rail member 11. Applying biasing forces to the two claw portions 61b in directions, in which the two claw portions 61b move closer to each other, enables attachment or detachment of the attachment 61 to or from the rail member 11 by operation of the two claw portions 61b, the operation being caused by the base portion 61a being pushed against the rail member 11 or the base portion 61a being separated from the rail member 11.

An insertion hole 61c where the fastening member 64 is inserted is formed in the base portion 61a. For example, the fastening member 64 is a screw and the insertion hole 61c is a screw hole. Inserting the fastening member 64 by a certain length into the insertion hole 61c restricts the operation of the two claw portions 61b. Therefore, inserting the fastening member 64 into the insertion hole 61c in a state where the rail member 11 has been held between the two claw portions 61b restricts operation of the claw portions 61b, the operation being in directions, in which the claw portions 61b separate from each other, and thus disables the attachment 61 from being separated and removed from the rail member 11. The base portion 61a and the claw portions 61b are formed of, for example, metal. Forming the base portion 61a and the claw portions 61b using metal improves rigidity of the attachment 61 and enables the attachment 61 to be fixed firmly to the rail member 11.

The spacer 62 is held between the extended portion 53 and the attachment 61. The spacer 62 is formed of insulative resin. A through hole 62a that lets the fastening member 64 penetrate through the spacer 62 is formed in the spacer 62.

The collar 63 is a so-called washer formed in a ring shape. The collar 63 is formed of insulative resin. The collar 63 is provided in front of the extended portion 53.

The fastening member 64 is a member to fix the attachment 61 and the spacer 62 to the extended portion 53. The fastening member 64 is, for example, a screw having a head portion 64a and a shaft portion 64b. Screw threads are formed on the shaft portion 64b. The shaft portion 64b is inserted in a through hole formed in the extended portion 53, the through hole 62a formed in the spacer 62, and the insertion hole 61c formed in the base portion 61a of the attachment 61. Screwing the shaft portion 64b in the insertion hole 61c fixes the attachment 61 and the spacer 62 in back of the extended portion 53. The collar 63 mentioned above is held between the head portion 64a of the fastening member 64 and the extended portion 53.

Fixing the attachment 61 to the rail member 11 in a state where the attachment 61 has been fixed to the extended portion 53 fixes the base 5 to the wall surface 10.

### Vibration Reduction Unit

As illustrated in FIG. 3 and FIG. 4, the vibration reduction unit 7 is mounted on the extended portion 53. FIG. 7 is an exploded perspective view of a vibration reduction unit. The vibration reduction unit 7 has a bracket 71 to be mounted on the extended portion 53. The bracket 71 has a fixed portion 71a to be fixed to the extended portion 53 by use of a screw, for example, and extended portions 71b extending backward (toward the wall surface) from the fixed portion 71a. A cutout 71c is formed in the fixed portion 71a such that the fixed portion 71a does not overlap the head portion 64a of the fastening member 64 for fixing, for example, the attachment 61 to the extended portion 53. The extended portions 71b are formed at two positions to have the attachment and detachment unit 6 interposed between these extended portions 71b along the short sides that are the outer edges of the mounting surface 51 in the front view.

The vibration reduction unit 7 has opposed portions 72 respectively mounted on distal ends of the extended portions 71b. The opposed portions 72 are opposed to the wall surface 10 by protruding more toward the wall surface 10 than the extended portion 53. The opposed portions 72 are formed of insulative resin. By being provided on the distal ends of the extended portions 71b, the opposed portions 72 are arranged along the short sides that are the outer edges of the mounting surface 51 in the front view and are provided to have the attachment and detachment unit 6 between the opposed portions 72. The opposed portions 72 may be mounted on the extended portions 71b by adhesion or by use of fastening members, such as screws.

As illustrated in FIG. 3 and FIG. 4, in a state where the base 5 has been fixed to the rail member 11 by the attachment and detachment unit 6, a distance D2 between the extended portion 53 and end surfaces of the opposed portions 72 is smaller than a distance D1 between the extended portion 53 and the wall surface 10. Therefore, a clearance has been formed between the opposed portions 72 and the wall surface 10.

### Module Unit

The module unit 4 is, for example, a control device exemplified by a programmable logic controller (PLC) or a distributed control system (DCS). The module unit 4 is configured to have plural modules, such as a power source unit 41 and a CPU unit 42. The plural modules that the module unit 4 has are held to be arranged in the leftward or rightward direction on the mounting surface 51 of the base 5. In a state where the plural modules have been held on the mounting surface 51, connectors (not illustrated in the drawings) respectively provided in the modules are connected to the connectors 51b provided on the mounting surface 51.

### Effects

The attachment and detachment unit 6 and the vibration reduction unit 7 for mounting the node unit 1 described above on the rail member 11 are provided, not in back of the mounting surface 51, but on the extended portion 53 extending out from the outer edges of the mounting surface 51. Therefore, the attachment and detachment unit 6 is easily accessed in attachment or detachment of the node unit 1 to or from the rail member 11 and ease of work for the attachment and detachment is thus improved.

Furthermore, firm fixing to the rail member 11 is achieved by the attachment 61 made of metal. The spacer 62 formed of resin is interposed between the attachment 61 and the extended portion 53 of the base 5, on the other hand. Therefore, the wall surface 10 and the rail member 11 are insulated from the base 5. Furthermore, because the opposed portions 72 extending in the back of the extended portion 53 and opposed to the wall surface 10 are formed of resin, the wall surface 10 and the base 5 are insulated from each other, even in a case where the opposed portions 72 have been abutted against the wall surface 10. Furthermore, because the collar 63 held between the head portion 64a of the fastening member 64 and the extended portion 53 is formed of insulative resin, the fastening member 64 and the extended portion 53 are insulated from each other. Therefore, the rail member 11 and the base 5 are prevented from being electrically connected to each other via the fastening member 64. The node unit 1 is thereby able to be installed by single-point grounding and influence of noise on the module unit 4 is thus able to be reduced.

The spacer 62 for insulation between the attachment 61 and the extended portion 53 may be formed as a resin portion covering the attachment 61, for example, instead of being formed separately from the attachment 61.

Furthermore, because the opposed portions 72 provided to have the attachment and detachment unit 6 between the opposed portions 72 along the short sides of the mounting surface 51 are opposed to the wall surface 10 in the vibration reduction unit 7, in a case where the node unit 1 vibrates vertically, the amplitude of the vertical vibration of the node unit 1 is reduced by the opposed portions 72 abutting against the wall surface 10. That is, the vibration reduction unit 7 reduces the vibration of the node unit 1. Furthermore, because the opposed portions 72 are formed of resin as described above, even in a case where the opposed portions 72 abut against the wall surface 10, insulation of the node unit 1 is maintained. In terms of the insulation upon the abutment of the opposed portions 72 against the wall surface 10, in a case where the opposed portions 72 are mounted on the extended portions 71b by means of metallic fastening members, such as screws, the fastening members are desirably configured to be not exposed on the end surfaces of the opposed portions 72 upon having been screwed in from a front side, the end surfaces being toward the wall surface 10.

Furthermore, because the vibration reduction unit 7 is formed separately from the attachment and detachment unit 6, the attachment and detachment unit 6 is able to be mounted without mounting of the vibration reduction unit 7 on the extended portion 53. Therefore, the vibration reduction unit 7 is able to be mounted on the extended portion 53 after the node unit 1 is fixed to the rail member 11 in a state where the vibration reduction unit 7 has not been mounted. In the state where the vibration reduction unit 7 has not been mounted, the attachment and detachment unit 6 is easily sighted and accessed, and ease of work upon fixing of the node unit 1 to the rail member 11 is thus improved.

Furthermore, a clearance has been formed between the opposed portions 72 and the wall surface 10 in a state where the vibration reduction unit 7 has been attached to the extended portion 53. Therefore, in a case where the vibration reduction unit 7 is to be attached afterward after the node unit 1 has been fixed to the rail member 11, the extended portions 71b and the opposed portions 72 do not need to push the extended portion 53 and the wall surface 10 apart to be inserted between the extended portion 53 and the wall surface 10. Ease of work upon later mounting of the vibration reduction unit 7 is thereby increased.

Furthermore, because the bracket 71 to be fixed to the extended portion 53 is formed of metal, the bracket 71 being of the vibration reduction unit 7, even in a case where the bracket 71 is fastened to the extended portion 53 by means of screws, breakage or damage is less likely to be caused. As long as sufficient strength of the bracket 71 is maintained, the bracket 71 may be formed of resin, and in that case, the bracket 71 and the opposed portions 72 may be formed integrally with each other.

Furthermore, the extended portion 53 is formed more forward than the mounting surface 51, that is, the extended portion 53 is formed at a position more separate from the wall surface 10 than that of the mounting surface 51. A distance between the extended portion 53 and the wall surface 10 thereby becomes larger than a distance between the mounting surface 51 and the wall surface 10. Therefore, as compared to a case where a spacer for insulation is provided between a mounting surface and a wall surface, forward protrusion of the mounting unit 2 (node unit 1) from the wall surface 10 is able to be lessened in the case where the spacer 62 is provided between the extended portion 53 and the attachment 61. Therefore, installation space for the node unit 1 in the control panel is able to be reduced.

### Re Structures

The module unit 4 mounted on the mounting surface 51 of the base 5 has been described as an example of a structure to be mounted on the rail member 11, but the structure is not limited to this example. For example, a box-shaped structure not separated into the base 5 and the module unit 4 may be directly mounted on the rail member 11. In this case, an extended portion may be formed to extend out from outer edges of the box-shaped structure. As long as the box-shaped structure has a structure vertically larger than the rail member 11, mounting the box-shaped structure using the mounting unit 2 achieves an effect of reducing vibration of the structure.

### Others

The following are some examples of a combination of technical features disclosed herein.
(1) A mounting unit for mounting a structure on a rail member provided on a wall surface, the mounting unit comprising: an attachment and detachment unit mounted on an extended portion extending out from an outer edge of the structure in a case where the attachment and detachment unit is viewed along a first direction perpendicular to the wall surface, the attachment and detachment unit being attachable to and detachable from the rail member; and at least two opposed portions that are mounted on the extended portion, opposed to the wall surface by protruding more toward the wall surface than the extended portion, and formed of resin, wherein the attachment and detachment unit has a resin portion that provides insulation between the rail member and the extended portion, and the opposed portions are provided to be arranged along the outer edge and are provided on both sides of the attachment and detachment unit, with the attachment and detachment unit interposed between the opposed portions.
(2) The mounting unit according to (1), further comprising: a bracket having the at least two opposed portions fixed to the bracket, wherein the at least two opposed portions are mounted on the extended portion by the bracket being mounted on the extended portion.
(3) The mounting unit according to (2), wherein the bracket is formed of metal.
(4) The mounting unit according to (2), wherein the bracket is formed of resin and is formed integrally with the opposed portions.
(5) The mounting unit according to any one of (1) to (4), wherein the opposed portions and the wall surface have a clearance formed between the opposed portions and the wall surface.
(6) The mounting unit according to any one of (1) to (5), wherein the attachment and detachment unit has: an attachment to be fixed to the rail member; a spacer to be held between the attachment and the extended portion and to serve as the resin portion; and a fastener that fastens the attachment and the extended portion together in a state where the spacer has been held between the attachment and the extended portion.
(7) A node unit, comprising: the mounting unit according to any one of (1) to (6); and a structure to be mounted on the rail member by means of the mounting unit, wherein the structure has: a base having a mounting surface parallel to the wall surface and having the extended portion formed thereon, the extended portion extending out from an outer edge of the mounting surface; and a module unit mounted on the mounting surface.
(8) The node unit according to (7), wherein the extended portion has been formed at a position more separate from the wall surface than that of the mounting surface.

The present invention has an effect of enabling obtainment of a mounting unit that increases ease of operation for attaching and detaching a structure to and from a wall surface.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A mounting unit (2) for mounting a structure on a rail member (11) provided on a wall surface (10), the mounting unit comprising:
an attachment and detachment unit (6) mounted on an extended portion (53) extending out from an outer edge of the structure in a case where the attachment and detachment unit is viewed along a first direction perpendicular to the wall surface, the attachment and detachment unit being attachable to and detachable from the rail member; and
at least two opposed portions (72) that are mounted on the extended portion, opposed to the wall surface by protruding more toward the wall surface than the extended portion, and formed of resin, wherein
the attachment and detachment unit has a resin portion that provides insulation between the rail member and the extended portion, and
the opposed portions are provided to be arranged along the outer edge and are provided on both sides of the attachment and detachment unit, with the attachment and detachment unit interposed between the opposed portions.

2. The mounting unit according to claim 1, further comprising:
a bracket (71) having the at least two opposed portions fixed to the bracket, wherein
the at least two opposed portions are mounted on the extended portion by the bracket being mounted on the extended portion.

3. The mounting unit according to claim 2, wherein the bracket is formed of metal.

4. The mounting unit according to claim 2, wherein the bracket is formed of resin and is formed integrally with the opposed portions.

5. The mounting unit according to any of claims 1 to 4, wherein the opposed portions and the wall surface have a clearance formed between the opposed portions and the wall surface.

6. The mounting unit according to any of claims 1 to 5, wherein the attachment and detachment unit has:
an attachment (61) to be fixed to the rail member;
a spacer (62) to be held between the attachment and the extended portion and to serve as the resin portion; and
a fastening member (64) that fastens the attachment and the extended portion together in a state where the spacer has been held between the attachment and the extended portion.

7. A node unit, comprising:
the mounting unit according to any of claims 1 to 6; and
a structure to be mounted on the rail member by means of the mounting unit, wherein
the structure has: a base (5) having a mounting surface parallel to the wall surface and having the extended portion formed thereon, the extended portion extending out from an outer edge of the mounting surface; and a module unit (4) mounted on the mounting surface.

8. The node unit according to claim 7, wherein the extended portion has been formed at a position more separate from the wall surface than that of the mounting surface.
